# FASCICULE DE BREVET EUROPEEN

(11) **EP 2 894 070 B1**
(45) Date de publication et mention de la délivrance du brevet: **28.07.2021**
(21) Numéro de dépôt: 15150196.2
(22) Date de dépôt: 06.01.2015
(51) Int. Cl.: B60T 17/22

(54) **Procédé de surveillance d'un organe de blocage, et actionneur électromécanique**
Überwachungsverfahren eines Blockierorgans, und elektromechanisches Stellglied
Method for monitoring a blocking member, and electromechanical actuator

(30) Priorité: 10.01.2014 FR 1450180
(43) Date de publication de la demande: 15.07.2015
(73) Titulaire: Safran Landing Systems, 78140 Vélizy-Villacoublay (FR)
(72) Inventeur: Lepage, Thomas, 78140 VELIZY-VILLACOUBLAY (FR); Chico, Philippe, 78140 VELIZY-VILLACOUBLAY (FR); Boningen, François, 78140 VELIZY-VILLACOUBLAY (FR); Ragot, Frédéric, 78140 VELIZY-VILLACOUBLAY (FR)
(74) Mandataire: Lavialle, Bruno François Stéphane

(56) Documents cités:
- WO-A1-2009/024168
- US-A1- 2005 258 683

## Description

L'invention concerne un procédé de surveillance d'un organe de blocage d'un actionneur électromécanique et un actionneur électromécanique comportant un organe de blocage surveillé par un tel procédé.

### ARRIERE PLAN DE L'INVENTION

Un frein électromécanique d'aéronef comporte en général au moins un actionneur électromécanique comprenant un moteur électrique et un poussoir actionné par le moteur électrique pour appliquer sélectivement un effort de presse sur des éléments de friction du frein, par exemple une pile de disques de carbone.

Pour réaliser la fonction de freinage de parc, c'est-à-dire l'immobilisation de l'aéronef sans que le pilote n'ait à appuyer continuellement sur les pédales de frein, l'actionneur électromécanique est muni d'un organe de blocage qui permet d'immobiliser sélectivement le poussoir de l'actionneur en position. En pratique, l'organe de blocage est par exemple un frein à manque de courant qui est alimenté en mode normal pour permettre le déplacement libre du poussoir de l'actionneur électromécanique sous l'action du moteur électrique, mais dont l'alimentation est coupée pour bloquer le poussoir en position lors du passage en mode de parc.

Il existe peu de moyens pour connaître l'état réel de l'organe de blocage de l'actionneur électromécanique, et donc pour détecter un éventuel dysfonctionnement de cet organe de blocage, par exemple un verrouillage accidentel de celui-ci. En outre, la mise en œuvre des moyens existants conduit à une augmentation non négligeable de la masse de l'actionneur électromécanique.

US 2005/258683 divulgue une procédé de surveillance d'un organe de blocage d'un actionneur électromécanique, l'organe de blocage pouvant bloquer en position un organe d'actionnement entraîné par un moteur électrique de l'actionneur électromécanique.

### OBJET DE L'INVENTION

L'invention a pour objet de surveiller un organe de blocage d'un actionneur électromécanique sans augmenter la masse de cet actionneur électromécanique.

### RESUME DE L'INVENTION

En vue de la réalisation de ce but, on propose un procédé de surveillance d'un organe de blocage d'un actionneur électromécanique, l'organe de blocage étant adapté à bloquer en position un organe d'actionnement entraîné par un moteur électrique de l'actionneur électromécanique, le procédé de surveillance comprenant les étapes de :
- déterminer une valeur représentative d'un courant d'alimentation du moteur électrique lors d'une phase de fonctionnement à vide de l'actionneur électromécanique ;
- comparer la valeur représentative du courant d'alimentation avec un seuil de courant prédéterminé, ledit seuil de courant prédéterminé étant défini à partir de caractéristiques nominales de fonctionnement à vide de l'actionneur électromécanique ;
- détecter un verrouillage accidentel de l'organe de blocage lorsque la valeur représentative du courant d'alimentation est supérieure au seuil de courant prédéterminé.

La surveillance de l'organe de blocage de l'actionneur électromécanique est donc réalisée par analyse d'une valeur représentative du courant d'alimentation du moteur électrique de l'actionneur électromécanique, ladite valeur représentative étant obtenue par exemple via une mesure dudit courant d'alimentation réalisée par un capteur de courant préexistant. Cette surveillance est donc effectuée sans qu'il soit nécessaire d'augmenter la masse de l'actionneur électromécanique.

On propose aussi un actionneur électromécanique comportant un organe d'actionnement, un moteur électrique adapté à entraîner l'organe d'actionnement et un organe de blocage adapté à bloquer en position l'organe d'actionnement. Selon l'invention, l'organe de blocage est surveillé par le procédé de surveillance décrit ci-dessus.

### BREVE DESCRIPTION DES DESSINS

L'invention sera mieux comprise à la lumière de la description qui suit en référence aux figures des dessins annexés parmi lesquelles :
- la figure 1 est une vue en coupe d'une demi-roue d'aéronef munie d'un frein comportant un actionneur électromécanique de l'invention ;
- la figure 2 est un graphique illustrant la position d'un poussoir et un courant d'alimentation d'un moteur électrique de l'actionneur lors d'un mouvement d'approche du poussoir vers une pile de disques du frein, l'actionneur comportant un organe de blocage surveillé par le procédé de surveillance de l'invention, l'organe de blocage étant normalement déverrouillé ;
- la figure 3 est un schéma fonctionnel représentant le procédé de surveillance de l'invention ;
- la figure 4 est un graphique similaire à celui de la figure 2 obtenu par des mesures réelles réalisées sur un véritable actionneur électromécanique ;
- la figure 5 est un graphique similaire à celui de la figure 2, illustrant cette fois un mouvement d'éloignement du poussoir ;
- la figure 6 est un graphique similaire à celui de la figure 4, illustrant cette fois un verrouillage accidentel de l'organe de blocage ;
- la figure 7 est un graphique similaire à celui de la figure 5, illustrant cette fois un verrouillage accidentel de l'organe de blocage.

### DESCRIPTION DETAILLEE DE L'INVENTION

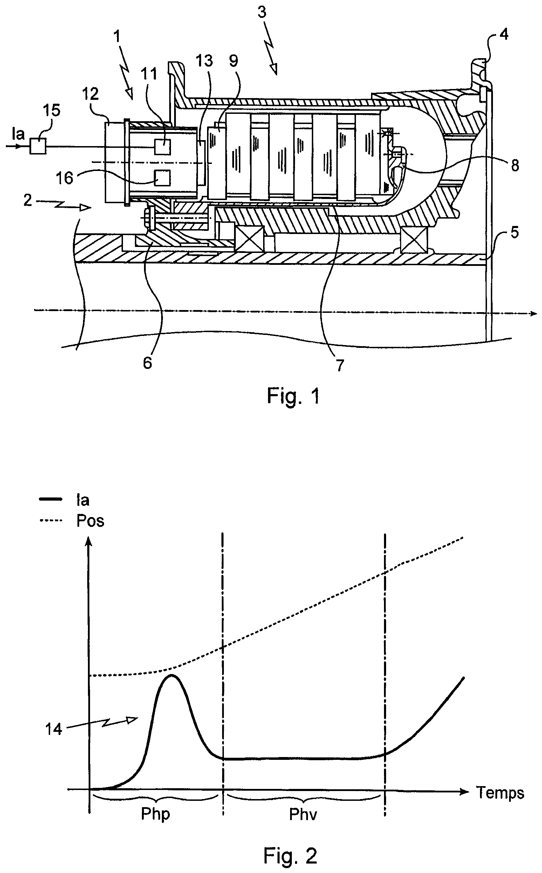

En référence à la figure 1, le procédé de surveillance de l'invention est ici utilisé pour surveiller un organe de blocage d'un actionneur électromécanique de freinage 1 de l'invention équipant un frein 2 d'une roue freinée 3 d'aéronef.

La roue freinée 3 comporte une jante 4 adaptée à recevoir un pneumatique (non représenté ici) et montée à rotation sur un essieu 5 porté par un atterrisseur de l'aéronef. Sur l'essieu 5 est montée une couronne 6 portant au moins un actionneur électromécanique semblable à l'actionneur électromécanique 1 de l'invention. Sur la couronne 6 est fixé un tube de torsion 7 qui s'étend dans la jante 4 pour se terminer par un appui 8. La couronne 6, et donc le tube de torsion 7, sont arrêtés en rotation vis-à-vis de l'essieu 5 par des moyens d'arrêt non représentés ici.

Entre l'appui 8 et l'actionneur électromécanique 1 s'étendent des éléments de friction du frein 2 constitués ici d'une pile de disques 9 composée de rotors qui sont solidaires en rotation de la jante 4 et de stators qui sont solidaires en rotation du tube de torsion 7.

L'actionneur électromécanique 1 comporte un organe d'actionnement, un moteur électrique 11 adapté à entraîner l'organe d'actionnement et un organe de blocage 12 adapté à bloquer en position l'organe d'actionnement.

L'organe d'actionnement comporte ici un poussoir 13 actionné par le moteur électrique 11 pour appliquer sélectivement un effort commandé sur la pile de disques 9. Cet effort commandé induit des efforts de friction entre les rotors et les stators de la pile de disque 9 et contribue à ralentir la rotation de la jante 4 et donc à freiner l'aéronef.

L'organe de blocage 12 est ici un frein à manque de courant qui, lorsqu'il est alimenté, laisse libre le poussoir 13 de l'actionneur électromécanique 1 de se déplacer sous l'action du moteur électrique 11 mais, lorsqu'il n'est plus alimenté, bloque le poussoir 13 en position.

L'actionneur électromécanique 1 est ainsi utilisé pour mettre en œuvre au moins deux modes de freinage : un mode de freinage commandé et un mode de freinage de parc.

Dans le mode de freinage commandé, le poussoir 13 de l'actionneur électromécanique 1 est déplacé vis-à-vis de la pile de disques 9 par le moteur électrique 11. Le moteur électrique 11 est alimenté par un courant d'alimentation Ia en fonction d'ordres de freinage reçus d'un calculateur de freinage non représenté.

Dans le mode de freinage de parc, le poussoir 13 est commandé pour exercer sur la pile de disques 9 un effort de parc, puis est bloqué en position par l'organe de blocage 12.

L'activation de chacun de ces modes de freinage génère un mouvement d'approche du poussoir 13, au cours duquel le poussoir 13 se déplace vers la pile de disques 9 sans être en contact avec celle-ci. De même, la désactivation de chacun de ces modes de freinage génère un mouvement d'éloignement du poussoir 13, au cours duquel le poussoir 13 s'éloigne de la pile de disques 9 sans être en contact avec celle-ci. Lors du mouvement d'approche du poussoir 13 et lors du mouvement d'éloignement du poussoir 13, l'actionneur électromécanique 1 n'applique aucun effort sur la pile de disques 9.

Le mouvement d'approche et le mouvement d'éloignement du poussoir 13 peuvent être décomposés en deux phases : une phase préliminaire et une phase de fonctionnement à vide. La figure 2 illustre la position Pos du poussoir 13 et le courant d'alimentation Ia du moteur électrique 11 de l'actionneur électromécanique 1 lors d'un mouvement d'approche du poussoir 13. Par convention, on considère que le courant d'alimentation Ia du moteur électrique 11 est positif lors du mouvement d'approche du poussoir 13.

Au cours de la phase préliminaire Php, le courant d'alimentation Ia du moteur électrique 11 présente la forme d'un pic de courant 14 correspondant à l'entrainement de l'inertie du poussoir 13. Cette phase préliminaire Php correspond à une phase d'accélération du poussoir 13. La position Pos du poussoir 13 varie de manière significative à partir de ce pic de courant 14.

Au cours de la phase de fonctionnement à vide Phv, le courant d'alimentation Ia du moteur électrique 11 est sensiblement constant. La vitesse du poussoir est stable, sensiblement constante, et la position Pos du poussoir 13 varie linéairement.

Le poussoir 13 a un comportement similaire lorsqu'il effectue un mouvement d'éloignement, si ce n'est que le courant d'alimentation Ia du moteur électrique 11 est négatif et que le mouvement du poussoir 13 est effectué en sens opposé.

Le procédé de surveillance de l'invention vise, lorsqu'un freinage est commandé, à détecter un verrouillage accidentel de l'organe de blocage 12, alors que celui-ci devrait normalement être déverrouillé pour permettre un libre déplacement du poussoir 13 de l'actionneur électromécanique 1. Le principe de fonctionnement du procédé de surveillance réside dans le fait que le courant d'alimentation Ia du moteur électrique 11 de l'actionneur électromécanique 1 est anormalement élevé lors d'une phase de fonctionnement à vide Phv lorsque l'organe de blocage 12 est anormalement verrouillé.

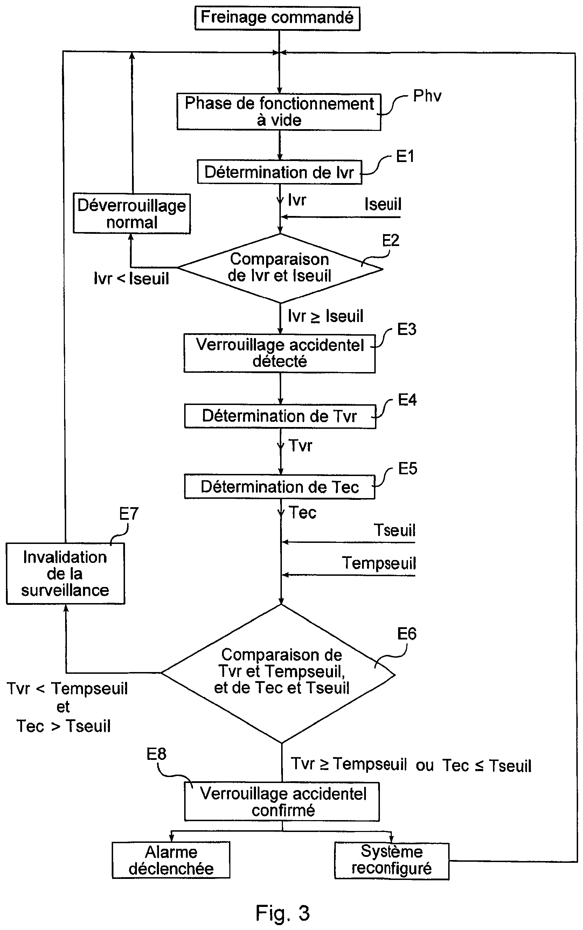

En référence à la figure 3, le procédé de surveillance de l'invention comporte pour cela une étape E1 au cours de laquelle une valeur représentative Ivr du courant d'alimentation Ia du moteur électrique 11 est déterminée lors d'une phase de fonctionnement à vide Phv de l'actionneur électromécanique 1 lors d'un mouvement d'approche du poussoir 13 ou lors d'un mouvement d'éloignement du poussoir 13. Ici, la valeur représentative du courant d'alimentation Ivr est une valeur absolue d'une moyenne de valeurs mesurées du courant d'alimentation Ia pendant une durée T. Le courant d'alimentation Ia du moteur électrique 11 est mesuré à l'aide d'un capteur de courant 15 (représenté schématiquement sur la figure 1) situé ici à l'extérieur de l'actionneur électromécanique 1. L'utilisation d'une moyenne du courant d'alimentation permet de supprimer au moins partiellement un bruit affectant la mesure du courant. L'utilisation d'une valeur absolue du courant permet de réaliser la mesure du courant d'alimentation au cours d'une phase de fonctionnement à vide Phv d'un mouvement d'approche ou d'un mouvement d'éloignement sans modifier le procédé de surveillance.

Le procédé de surveillance de l'invention comporte ensuite une étape E2 au cours de laquelle la valeur représentative du courant d'alimentation Ivr est comparée avec un seuil de courant prédéterminé Iseuil. Le seuil de courant prédéterminé Iseuil est défini à partir de caractéristiques nominales de fonctionnement à vide de l'actionneur électromécanique 1.

Le procédé de surveillance de l'invention comporte ensuite une étape E3 au cours de laquelle un verrouillage accidentel de l'organe de blocage 12 est détecté lorsque la valeur représentative du courant d'alimentation Ivr est supérieure ou égale au seuil de courant prédéterminé Iseuil. Si la valeur représentative du courant d'alimentation Ivr est strictement inférieure au seuil de courant prédéterminé Iseuil, un déverrouillage normal de l'organe de blocage est détecté.

Dans le cas où un verrouillage accidentel de l'organe de blocage est détecté, le procédé de surveillance de l'invention comporte des étapes de confirmation pour confirmer le verrouillage accidentel.

Le principe de ces étapes de confirmation réside tout d'abord dans le fait que, lorsque la température ambiante dans laquelle évolue l'actionneur électromécanique 1 est faible, des frottements internes à l'actionneur électromécanique 1 sont importants, ce qui peut conduire à une hausse du courant d'alimentation Ia du moteur électrique 11 lors du fonctionnement à vide de l'actionneur électromécanique 1. Le principe de ces étapes de confirmation réside ensuite dans le fait que, si un temps écoulé Tec depuis une utilisation précédente de l'actionneur électromécanique 1 est relativement faible, l'actionneur électromécanique 1 n'aura pas eu le temps de refroidir et son fonctionnement ne sera donc pas perturbé par des frottements internes.

Les étapes de confirmation comprennent ainsi une étape E4 au cours de laquelle une valeur représentative d'une température Tvr de l'actionneur électromécanique 1 est déterminée, et une étape E5 au cours de laquelle un temps écoulé Tec depuis une utilisation précédente de l'actionneur électromécanique 1 est déterminée. La valeur représentative de la température Tvr de l'actionneur électromécanique 1 est ici une mesure de la température interne de l'actionneur électromécanique 1 réalisée par un capteur de température 16 situé à l'intérieur de l'actionneur électromécanique 1.

Les étapes de confirmation comprennent ensuite une étape E6 au cours de laquelle la valeur représentative de la température Tvr de l'actionneur électromécanique 1 est comparée avec un seuil de température prédéterminé Tempseuil, et une étape au cours de laquelle le temps écoulé Tec est comparé avec un seuil temporel prédéterminé Tseuil.

Les étapes de confirmation comprennent en outre une étape E7 qui permet d'invalider la surveillance de l'organe de blocage 12 lorsque la valeur représentative de la température Tvr de l'actionneur électromécanique 1 est strictement inférieure au seuil de température prédéterminé Tempseuil et lorsque le temps écoulé Tec est strictement supérieur au seuil temporel prédéterminé Tseuil, et l'étape E8 qui permet de confirmer le verrouillage accidentel de l'organe de blocage 12 lorsque la valeur représentative de la température Tvr de l'actionneur électromécanique 1 est supérieure ou égale au seuil de température prédéterminé Tempseuil ou lorsque le temps écoulé Tec est inférieur ou égal au seuil temporel prédéterminé Tseuil.

Lorsque que le verrouillage accidentel de l'organe de blocage 12 est détecté, une alarme est déclenchée pour avertir le pilote et/ou pour générer un message de panne à destination d'un calculateur quelconque d'un système de freinage intégrant l'actionneur électromécanique 1. Une reconfiguration ou une autocorrection du système de freinage peut alors être commandée, pour tenter de corriger le verrouillage accidentel de l'organe de blocage 12 et pour remettre l'actionneur électromécanique 1 dans des conditions de fonctionnement normales.

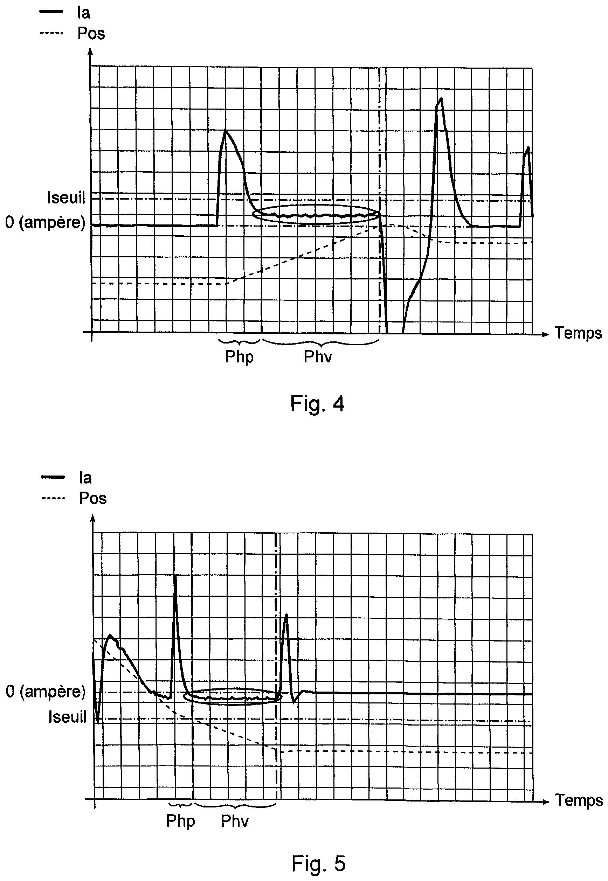

Les figures 4 à 7, obtenues par des mesures réalisées sur un véritable actionneur électromécanique monté sur un véritable frein d'aéronef, permettent d'illustrer le principe du procédé de surveillance selon lequel le courant d'alimentation Ia du moteur électrique 11 de l'actionneur électromécanique 1 est anormalement élevé lors d'une phase de fonctionnement à vide Phv lorsque l'organe de blocage 12 est anormalement verrouillé.

La figure 4 illustre la position du poussoir 13 et le courant d'alimentation Ia du moteur électrique 11 de l'actionneur électromécanique 1 lors d'un mouvement d'approche du poussoir 13 alors que l'organe de blocage 12 est normalement déverrouillé. On note que le courant d'alimentation Ia est inférieur au seuil de courant prédéterminé Iseuil pendant la phase de fonctionnement à vide Phv de l'actionneur électromécanique 1.

La figure 5 illustre la position du poussoir 13 et le courant d'alimentation Ia du moteur électrique 11 de l'actionneur électromécanique 1 lors d'un mouvement d'éloignement du poussoir 13 alors que l'organe de blocage 12 est normalement déverrouillé. On note que le courant d'alimentation la est inférieur en valeur absolue au seuil de courant prédéterminé Iseuil (négatif ici) pendant la phase de fonctionnement à vide Phv de l'actionneur électromécanique 1.

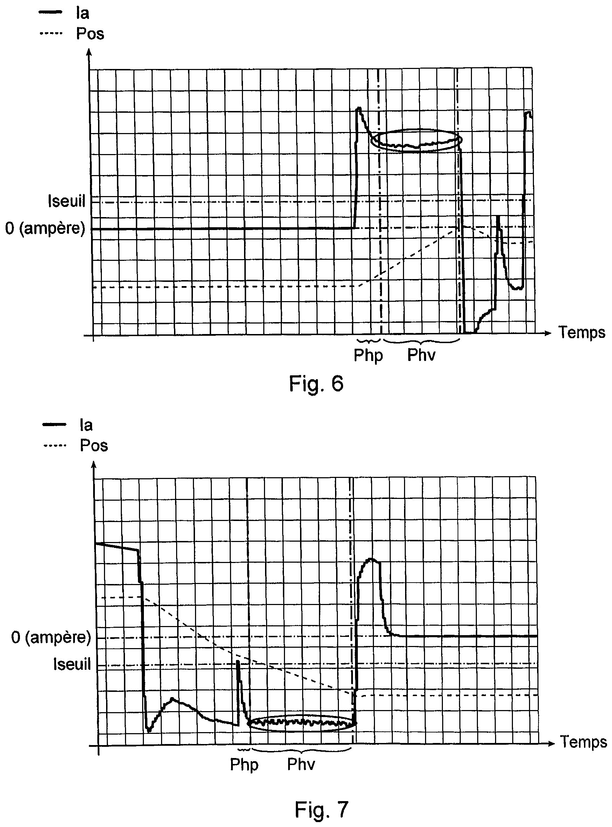

La figure 6 illustre la position du poussoir 13 et le courant d'alimentation Ia du moteur électrique 11 de l'actionneur électromécanique 1 lors d'un mouvement d'approche du poussoir 13 alors que l'organe de blocage 12 est anormalement verrouillé. On note que le courant d'alimentation Ia est nettement supérieur au seuil de courant prédéterminé Iseuil pendant la phase de fonctionnement à vide Phv de l'actionneur électromécanique 1.

La figure 7 illustre la position du poussoir 13 et le courant d'alimentation Ia du moteur électrique 11 de l'actionneur électromécanique 1 lors d'un mouvement d'éloignement du poussoir 13 alors que l'organe de blocage 12 est anormalement verrouillé. On note que le courant d'alimentation Ia est nettement supérieur en valeur absolue au seuil de courant prédéterminé Iseuil pendant la phase de fonctionnement à vide de l'actionneur électromécanique 1.

L'invention n'est pas limitée au mode de mise en œuvre particulier qui vient d'être décrit, mais, bien au contraire, couvre toute variante entrant dans le cadre de l'invention telle que définie par les revendications.

Il est en particulier possible de mettre en œuvre le procédé de surveillance de l'invention pour surveiller un organe de blocage d'un actionneur électromécanique quelconque muni d'un tel organe de blocage.

Bien que l'on ait indiqué que la valeur représentative du courant d'alimentation est une valeur absolue d'une moyenne de valeurs mesurées du courant d'alimentation, cette valeur représentative du courant d'alimentation peut être différente : il est par exemple possible d'utiliser directement une valeur mesurée du courant, ou bien d'utiliser une autre grandeur représentative du courant d'alimentation (grandeur électrique différente, etc.). Le capteur de courant peut bien sûr aussi être positionné directement dans l'actionneur électromécanique.

De même, la valeur représentative de la température de l'actionneur électromécanique peut être obtenue différemment, par exemple via une sonde de température du frein, ou par analyse d'un paramètre ne nécessitant pas de capteur de température (par exemple la variation de résistance d'un bobinage du moteur électrique ou bien, lorsque l'organe de blocage est un frein à manque de courant, d'un bobinage dudit frein à manque de courant).

On note en outre que la phase de fonctionnement à vide, au cours de laquelle est déterminée la valeur représentative d'un courant d'alimentation du moteur électrique, peut être une phase de fonctionnement associée aussi bien à un freinage en mode de parc qu'à un freinage en mode commandé lorsque l'aéronef roule (atterrissage, taxiage).

## Revendications

1. Procédé de surveillance d'un organe de blocage (12) d'un actionneur électromécanique (1), l'organe de blocage (12) étant adapté à bloquer en position un organe d'actionnement entraîné par un moteur électrique (11) de l'actionneur électromécanique (1), **caractérisé en ce que** le procédé de surveillance comprenant les étapes de :
- déterminer une valeur représentative d'un courant d'alimentation (Ivr) du moteur électrique (11) lors d'une phase de fonctionnement à vide (Phv) de l'actionneur électromécanique (1) ;
- comparer la valeur représentative du courant d'alimentation avec un seuil de courant prédéterminé (Iseuil), ledit seuil de courant prédéterminé étant défini à partir de caractéristiques nominales de fonctionnement à vide de l'actionneur électromécanique (1) ;
- détecter un verrouillage accidentel de l'organe de blocage (12) lorsque la valeur représentative du courant d'alimentation est supérieure ou égale au seuil de courant prédéterminé.

2. Procédé de surveillance selon la revendication 1, dans lequel la valeur représentative du courant d'alimentation (Ivr) est une valeur absolue d'une moyenne de valeurs mesurées du courant d'alimentation (Ia).

3. Procédé de surveillance selon l'une des revendications précédentes comportant en outre des étapes de confirmation destinées, lorsqu'un verrouillage accidentel de l'organe de blocage (12) est détecté, à confirmer ledit verrouillage accidentel, lesdites étapes de confirmation comprenant les étapes de :
- déterminer une valeur représentative d'une température (Tvr) de l'actionneur électromécanique (1) ;
- comparer la valeur représentative (Tvr) de la température de l'actionneur électromécanique avec un seuil de température prédéterminé (Tempseuil).

4. Procédé de surveillance selon la revendication 3, dans lequel les étapes de confirmation comprennent en outre les étapes de :
- déterminer un temps écoulé (Tec) depuis une utilisation précédente de l'actionneur électromécanique (1) ;
- comparer le temps écoulé (Tec) avec un seuil temporel prédéterminé (Tseuil).

5. Procédé de surveillance selon les revendications 3 et 4, dans lequel les étapes de confirmation comprennent en outre les étapes de :
- invalider la surveillance de l'organe de blocage (12) lorsque la valeur représentative de la température (Tvr) de l'actionneur électromécanique (1) est strictement inférieure au seuil de température prédéterminé (Tempseuil) et lorsque le temps écoulé (Tec) est strictement supérieur au seuil temporel prédéterminé (Tseuil) ;
- confirmer le verrouillage accidentel de l'organe de blocage (12) lorsque la valeur représentative de la température (Tvr) de l'actionneur électromécanique (1) est supérieure ou égale au seuil de température prédéterminé (Tempseuil) ou lorsque le temps écoulé (Tec) est inférieur ou égal au seuil temporel prédéterminé (Tseuil).

6. Procédé de surveillance selon l'une des revendications précédentes comportant en outre, lorsqu'un verrouillage accidentel de l'organe de blocage (12) est détecté, une étape de reconfiguration ou d'autocorrection destinée à tenter de déverrouiller l'organe de blocage (12).

7. Système de freinage comprenant un calculateur et un actionneur électromécanique, l'actionneur électromécanique comportant un organe d'actionnement, un moteur électrique (11) adapté à entraîner l'organe d'actionnement et un organe de blocage (12) adapté à bloquer en position l'organe d'actionnement, **caractérisé en ce que** le calculateur comporte des moyens adaptés à mettre en œuvre le procédé de surveillance selon l'une des revendications 1 à 6 pour surveiller l'organe de blocage (12).

8. Système de freinage selon la revendication 7, l'actionneur électromécanique (1) étant un actionneur de freinage équipant un frein (2) d'une roue (3) d'aéronef, l'organe d'actionnement comportant un poussoir (13) actionné par le moteur électrique (11) pour appliquer sélectivement un effort commandé sur des éléments de friction (9) du frein (2).

## Patentansprüche

1. Verfahren zum Überwachen eines Blockierelements (12) eines elektromechanischen Aktors (1), wobei das Blockierelement (12) angepasst ist, ein von einem Elektromotor (11) des elektromechanischen Aktors (1) angetriebenes Betätigungselement in Position zu blockieren, **dadurch gekennzeichnet, dass** das Überwachungsverfahren die Schritte umfasst:
- Bestimmen eines Wertes, der repräsentativ für einen Versorgungsstrom (Ivr) des Elektromotors (11) während einer Leerlauf-Betriebsphase (Phv) des elektromechanischen Aktors (1) ist;
- Vergleichen des Versorgungsstrom-Repräsentativwerts mit einem vorbestimmten Stromschwellenwert (Iseuil), wobei der genannte vorbestimmte Stromschwellenwert anhand von nominalen Leerlaufbetriebseigenschaften des elektromechanischen Aktors (1) definiert ist;
- Erfassen einer unbeabsichtigten Verriegelung des Blockierelements (12), wenn der Versorgungsstrom-Repräsentativwert größer oder gleich dem vorbestimmten Stromschwellenwert ist.

2. Überwachungsverfahren nach Anspruch 1, bei dem der Versorgungsstrom-Repräsentativwert (Ivr) ein Absolutwert eines Mittelwerts von gemessenen Werten des Versorgungsstroms (la) ist.

3. Überwachungsverfahren nach einem der vorhergehenden Ansprüche, ferner umfassend Bestätigungsschritte, die, wenn eine unbeabsichtigte Verriegelung des Blockierelements (12) erfasst wird, dazu bestimmt sind, die unbeabsichtigte Verriegelung zu bestätigen, wobei die genannten Bestätigungsschritte die Schritte umfassen:
- Bestimmen eines Temperatur-Repräsentativwerts (Tvr) des elektromechanischen Aktors (1);
- Vergleichen des Temperatur-Repräsentativwerts (Tvr) des elektromechanischen Aktors mit einem vorbestimmten Temperaturschwellenwert (Tempseuil).

4. Überwachungsverfahren nach Anspruch 3, bei dem die Bestätigungsschritte ferner die Schritte umfassen:
- Bestimmen einer verstrichenen Zeit (Tec) ab einer vorherigen Nutzung des elektromechanischen Aktors (1);
- Vergleichen der verstrichenen Zeit (Tec) mit einem vorbestimmten Zeitschwellenwert (Tseuil).

5. Überwachungsverfahren nach einem der Ansprüche 3 und 4, bei dem die Bestätigungsschritte ferner die Schritte umfassen:
- Deaktivieren der Überwachung des Blockierelements (12), wenn der Temperatur-Repräsentativwert (Tvr) des elektromechanischen Aktors (1) streng kleiner als der vorbestimmte Temperaturschwellenwert (Tempseuil) ist und wenn die verstrichene Zeit (Tec) streng größer als der vorbestimmte Zeitschwellenwert (Tseuil) ist;
- Bestätigen der unbeabsichtigten Verriegelung des Blockierelements (12), wenn der Temperatur-Repräsentativwert (Tvr) des elektromechanischen Aktors (1) größer oder gleich dem vorbestimmten Temperaturschwellenwert (Tempseuil) ist oder wenn die verstrichene Zeit (Tec) kleiner oder gleich dem vorbestimmten Zeitschwellenwert (Tseuil) ist.

6. Überwachungsverfahren nach einem der vorhergehenden Ansprüche, ferner umfassend, wenn eine unbeabsichtigte Verriegelung des Blockierelements (12) erfasst wird, einen Schritt der Rekonfiguration oder Autokorrektur, der dazu bestimmt ist, zu versuchen das Blockierelement zu entriegeln (12).

7. Bremssystem, umfassend einen Rechner und einen elektromechanischen Aktor, wobei der elektromechanische Aktor ein Betätigungselement, einen Elektromotor (11), der angepasst ist, das Betätigungselement anzutreiben, und ein Blockierelement (12) umfasst, das angepasst ist, das Betätigungselement in Position zu blockieren, **dadurch gekennzeichnet, dass** der Rechner Mittel umfasst, die angepasst sind, das Überwachungsverfahren nach einem der Ansprüche 1 bis 6 zum Überwachen des Blockierelements (12) durchzuführen.

8. Bremssystem nach Anspruch 7, wobei der elektromechanische Aktor (1) ein Bremsaktor ist, mit dem eine Bremse (2) eines Rades (3) eines Luftfahrzeugs ausgestattet ist, wobei das Betätigungselement einen Stößel (13) umfasst, der von dem Elektromotor (11) betätigt wird, um selektiv eine gesteuerte Kraft auf Reibelemente (9) der Bremse (2) aufzubringen.

## Claims

1. Method for monitoring a blocking member (12) of an electromechanical actuator (1), the blocking member (12) being adapted to block in position an actuation member driven by an electric motor (11) of the electromechanical actuator (1), **characterized in that** the monitoring method comprising the steps of:
- determining a value representative of a power supply current (Ivr) of the electric motor (11) during an off-load operating phase (Phv) of the electromechanical actuator (1);
- comparing the value representative of the power supply current with a predetermined current threshold (Ithresh), said predetermined current threshold being defined from nominal off-load operating characteristics of the electromechanical actuator (1);
- detecting an accidental locking of the blocking member (12) when the value representative of the power supply current is above or equal to the predetermined current threshold.

2. Monitoring method according to Claim 1, in which the value representative of the power supply current (Ivr) is an absolute value of an average of measured values of the power supply current (Ia).

3. Monitoring method according to one of the preceding claims, further comprising confirmation steps intended, when an accidental locking of the blocking member (12) is detected, to confirm said accidental locking, said confirmation steps comprising the steps of:
- determining a value representative of a temperature (Tvr) of the electromechanical actuator (1);
- comparing the value (Tvr) representative of the temperature of the electromechanical actuator with a predetermined temperature threshold (Tempthresh).

4. Monitoring method according to Claim 3, in which the confirmation steps further comprise the steps of:
- determining an elapsed time (Tec) since a previous use of the electromechanical actuator (1);
- comparing the elapsed time (Tec) with a predetermined time threshold (Tthresh).

5. Monitoring method according to Claims 3 and 4, in which the confirmation steps further comprise the steps of:
- disabling the monitoring of the blocking member (12) when the value representative of the temperature (Tvr) of the electromechanical actuator (1) is strictly below the predetermined temperature threshold (Tempthresh) and when the elapsed time (Tec) is strictly above the predetermined time threshold (Tthresh);
- confirming the accidental locking of the blocking member (12) when the value representative of the temperature (Tvr) of the electromechanical actuator (1) is above or equal to the predetermined temperature threshold (Tempthresh) or when the elapsed time (Tec) is below or equal to the predetermined time threshold (Tthresh) .

6. Monitoring method according to one of the preceding claims, further comprising, when an accidental locking of the blocking member (12) is detected, a reconfiguration or self-correction step intended to try to unlock the blocking member (12).

7. Braking system comprising a computer and an electromechanical actuator, the electromechanical actuator comprising an actuation member, an electric motor (11) adapted to drive the actuation member and a blocking member (12) adapted to blocking in position the actuation member, **characterised in that** the computer comprises means adapted to perform the monitoring method according to one of Claims 1 to 6 in order to monitor the blocking member (12).

8. Braking system according to Claim 7, the electromechanical actuator (1) being a braking actuator with which a brake (2) of an aircraft wheel (3) is equipped, the actuation member comprising a plunger (13) actuated by the electric motor (11) to selectively apply a controlled force to friction elements (9) of the brake (2).
